# EUROPÄISCHE PATENTSCHRIFT

(11) **EP 2 101 949 B1**
(45) Veröffentlichungstag und Bekanntmachung des Hinweises auf die Patenterteilung: **23.01.2013**
(21) Anmeldenummer: 07856364.0
(22) Anmeldetag: 04.12.2007
(51) Int. Cl.: B23K 1/08, B23K 3/06, H05K 3/34, B23K 101/42

(54) **VORRICHTUNG UND VERFAHREN ZUM SELEKTIVLÖTEN**
DEVICE AND METHOD FOR SELECTIVE SOLDERING
DISPOSITIF ET PROCÉDÉ DE BRASAGE SÉLECTIF

(30) Priorität: 18.01.2007 DE 102007002777; 13.03.2007 EP 07005179
(43) Veröffentlichungstag der Anmeldung: 23.09.2009
(73) Patentinhaber: Linde AG, 80331 München (DE); EPM Handels GmbH, 8954 Geroldswill (CH)
(72) Erfinder: ISLER, Hans, CH-5454 Bellinkon (CH); WANDKE, Ernst, 82538 Geretsried (DE)
(74) Vertreter: Gellner, Bernd
(86) Internationale Anmeldenummer: PCT/EP2007/010523
(87) Internationale Veröffentlichungsnummer: WO 2008/086842

(56) Entgegenhaltungen:
- EP-A- 1 674 186
- DE-U1- 20 220 971
- NL-C2- 1 013 640
- US-B1- 6 705 506

## Beschreibung

Die vorliegende Erfindung betrifft eine Vorrichtung zum Selektivlöten nach dem Oberbegriff des Anspruchs 1 aufweisend einen Behälter für flüssiges Lot, der ein sog. Lotbad enthält, mit einem Lotkanal und mindestens einer auf den Lotkanal aufgesetzten Düse und einer Lotpumpe zum unter Druck Setzen von flüssigem Lot im Lotkanal. Desweiteren betrifft die vorliegende Erfindung ein Verfahren zum Selektivlöten nach dem Oberbegriff des Anspruchs 5. Einesolche Vorrichtung und ein solches Verfahren sind aus der DE 202 20 971 U1 bekannt.

Das Selektivlöten ist ein zum Löten von Elektronikbaugruppen etabliertes Verfahren. Besonders für große und schwere Bauelemente wie Trafos, Stecker, ELKOS und andere, die z.B. einer hohen mechanischen Belastung ausgesetzt sein können, hat es sich als vorteilhaft erwiesen. Solche Bauelemente werden bevorzugt nach der sog. Durchstecktechnik im Selektivlötverfahren gelötet. Das Selektivlötverfahren kann als örtlich begrenztes Lötverfahren beschrieben werden, bei dem das flüssige Lot meist über senkrechte Düsen den Lötstellen zugeführt wird. Zu diesem Zweck kann am oberen Ende der Düsen auch eine Mini-Lötwelle erzeugt werden. In der Druckschrift DE 4314 241 C2 ist eine Vorrichtung zum Selektivlöten mit den vorstehend beschriebenen Eigenschaften offenbart.

Im Stand der Technik muss das Freiliegen von Lot an den oberen Enden der Düsen, vor allem in den Pausen zwischen zwei Lötvorgängen, also im Stand-by-Modus einer Selektivlötanlage als nachteilig betrachtet werden. Ebenso sind die relativ geringe Inertisierung während des Lötprozesses und eine damit verbundene verstärkte Krätzebildung sowie eine erhöhte Fehlerrate als Nachteile zu nennen.

Das Dokument DE 202 20 971 U1 offenbart ein Verfahren zum Selektivlöten, bei dem durch den Einsatz einer beweglichen Haube der Schutz des Lots vor Oxidation deutlich verbessert ist.

Aufgabe der vorliegenden Erfindung ist es, eine verbesserte Vorrichtung und ein weiter verbessertes Verfahren zum Selektivlöten zur Verfügung zu stellen.

Vorrichtungsseitig wird die gestellte Aufgabe dadurch gelöst, dass der Lotkanal von einer vertikal bewegbaren Haube umgeben ist, die in das Lotbad eintaucht oder anderweitig zur Oberfläche des Lotbades abgedichtet ist und die für jede Düse einen Durchbruch aufweist, und mindestens eine Eintragsvorrichtung für Schutz- und/oder Aktivgas unter der Haube vorgesehen ist, wobei Strömungsbleche (8) an der Haube (5) angebracht sind, die sich von der Haube im wesentlichen abwärts Richtung Lotbad erstrecken.

Die erfindungsgemäße Vorrichtung besitzt eine oder mehr als eine auf dem Lotkanal aufgesetzte Düsen.

Aufgrund der geringen Dimensionen und der begrenzten Lotmenge, die zum Einsatz kommt, ist der Einsatz von Schutz- und/oder Aktivgas für einen problemlosen Betrieb der Vorrichtung besonders wichtig. In der Regel wird eine inertes Schutzgas vorteilhaft sein. In besonderen Fällen kann ein Aktivgas besonderen Vorteil bringen. Im folgenden wird nur noch der Begriff Schutzgas oder Schutzgasamtosphäre verwendet, wobei mmer auch ein Aktivgas oder eine Aktivgasatmosphäre von diesem Begriff mit umfasst sein soll.

Die erfindungsgemäße Haube ermöglicht ein Einhüllen der oberen Enden der Düsen in die Schutzgasamtosphäre, wodurch der Verschmutzungsgrad der Lötstellen und die Fehlerquote beim Löten vorteilhaft gesenkt werden kann.

Es stellt einen besonderen Vorteil dar, dass die Haube als Schutzgasabdeckung in senkrechter Richtung verschiebbar angeordnet ist und somit im Stand-by-Modus, also zwischen zwei Lötvorgängen, die Düsen vollständig von der Schutzgasatmosphäre eingehüllt sind und im Lötprozess nur der für den direkten Kontakt mit den zu lötenden Bauteilen oberste Teil der Düse freigegeben wird und dadurch im Löt-Modus nahezu ideal von Schutzgas umspült wird.

Durch die an der Haube angebrachten Strömungsbleche wird die inertisierende Wirkung des Schutzgases weiter verbessert werden. Eine besonders vorteilhafte Möglichkeit zur Anbringung der Strömungsbleche ist an der Haube und abwärts Richtung Lotbad gerichtet.

Die Eintragsvorrichungen für Schutzgas können vorteilhaft als Gaslanzen ausgebildet sein.

Bevorzugt ist das obere Ende der Düse als Lötkopf zur Ausbildung einer Lötwelle ausgebildet.

Mit besonderem Vorteil ist der obere Abschluss des Lotkanals als Deckblech ausgebildet. Das Deckblech schließt dicht mit dem Lotkanal ab und wird von den Düsen durchbrochen und fixiert diese.

Gemäß einer vorteilhaften Weiterbildung der Erfindung sind zur Abdeckung der Durchbrüche in der Haube zusätzliche Bleche vorgesehen. Mit diesen zusätzlichen Blechen kann die insgesamt erforderliche Schutzgasmenge erfolgreich weiter reduziert werden.

Verfahrensseitig wird die gestellte Aufgabe durch ein Verfahren gelöst, das folgende Schritte aufweist:
1) eine zu lötende und dafür vorbereitete Leiterplatte wird in einen Lötbereich transportiert,
2) entweder die Leiterplatte und die Haube zeitgleich zusammen abgesenkt werden und/oder die Leiterplatte auf einer zuvor abgesenkten Haube positioniert wird,
3) dann wird der Lötvorgang durchgeführt, wobei über die mindestens eine Düse Lot aus einem Lotkanal nach oben zur Lötstelle gepumpt wird und wobei während des Lötvorganges über eine Eintragsvorrichtung Schutz- und/oder Aktivgas eingebracht wird und
4) nach Beendigung des Lötvorganges die Leiterplatte den Lötbereich verläßt und die Einhausung des Lötbereichs durch Anheben der Haube wieder aufgehoben wird und
5) zwischen zwei Lötvorgängen die Durchbrüche (7) mit zusätzlichen, den einzelnen Durchbrüchen zugeordneten Blechen (11) abgedeckt werden,
wobei eine Vorrichtung nach einem der Ansprüche 1 bis 4 verwendet wird.

Der Begriff der vorbereiteten Leiterplatte meint hier insbesondere eine bestückte, gefluxte und in der Regel vorgewärmte Leiterplatte.

Dadurch dass zwischen zwei Lötvorgängen die Durchbrüche in der Haube mit zusätzlichen Blechen abgedeckt werden, kann im sog. Stand-by-Modus die erforderliche Menge an Schutzgas weiter reduziert und die Inertisierungswirkung verbessert werden. Die zusätzlichen Bleche werden vorteilhaft mit der Absenkbewegung der Haube zu Beginn eines Lötvorganges entfernt, so dass die Durchbrüche 7 während des Lötvorgangs offen sind. Erst mit der Aufwärtsbewegung der Haube nach Beendigung eines Lötvorganges werden die zusätzlichen Bleche wieder über den Durchbrüchen positioniert und diese damit verschlossen.

Mit besonderem Vorteil wird einer erste Menge pro Zeiteinheit an Schutz- und/oder Aktivgas während des Lötvorganges eingebracht und eine zweite Menge pro Zeiteinheit an Schutz- und/oder Aktivgas zwischen zwei Lötvorgängen eingebracht.

Besonders bevorzugt wird nach Beendigung des Lötvorganges die Menge des über die Eintragsvorrichtung eingebrachten Schutz- und/oder Aktivgases gegenüber der während dem Lötvorgang eingebrachten Menge reduziert.

Zweckmäßigerweise wird die Haube vor Beginn des Lötvorganges auf ein Niveau abgesenkt wird, das auf die unterseitige Bauteilgeometrie der Leiterplatte abgestimmt ist und etwas unter dem tiefsten Punkt der zu lötenden Baugruppe liegt.

Die vorliegende Erfindung bietet eine ganze Reihe von Vorteilen. Im folgenden sind exemplarisch einige davon genannt: Die Effizienz der Ausnutzung des eingesetzten Schutzgases wird verbessert, die Lötqualität wird erhöht, die Krätzebildung wird vermindert und der Wartungsaufwand und die Betriebskosten können mit der vorliegenden Erfindung gesenkt werden.

Die Erfindung sowie weitere Ausgestaltungen der Erfindung werden im Folgenden anhand der in den Figuren dargestellten Ausführungsbeispiele näher erläutert. Die Figuren zeigen:
Figur 1 eine erfindungsgemäße Vorrichtung zum Selektivlöten,
Figur 2eine Weiterbildung einer erfindungsgemäßen Vorrichtung mit zusätzlichen Blechen zur Abdeckung

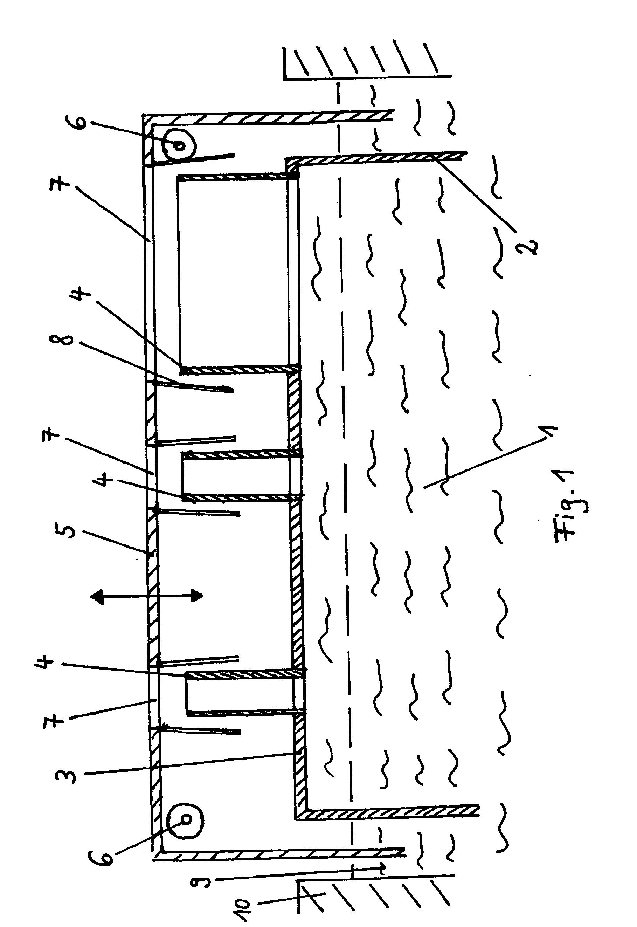

Im Einzelnen zeigt die Figur 1 einen Behälter 10 für flüssiges Lot, der ein sog. Lotbad 9 enthält, mit einem Lotkanal 2. Desweiteren sind in der Figur drei Düsen 4 dargestellt, die auf den Lotkanal 2 aufgesetzt sind. Der Lotkanal 2 ist in diesem Beispiel und in der Regel als Druckkanal ausgebildet und zur Umgebung hin als abgeschlossen zu betrachten. In der Figur ist der Lotkanal 2 nur teilweise dargestellt.

Die Düsen 4 sind im Bereich des Deckbleches 3 auf den Lotkanal 2 aufgesetzt und werden von diesem fixiert. Um das flüssige Lot 1 unter Druck zu setzen ist eine Lotpumpe vorgesehen (nicht dargestellt). Der Lotkanal 2 ist von einer vertikal bewegbaren Haube 5 umgeben, die in das Lotbad 9 eintaucht und auf diese Weise zur Oberfläche des Lotbades 9 abgedichtet ist. Für jede Düse 4 ist in der Haube 5 ein Durchbruch 7 vorgesehen. Desweiteren sind in diesem Beispiel zwei Eintragsvorrichtungen 6 für Schutzgas vorgesehen, die dem Einbringen von Schutzgas unter die Haube 5 dienen.

Über die Eintragsvorrichtungen 6 wird beispielsweise Stickstoff als inertisierendes Schutzgas eingeblasen. Dabei sind die Eintragsvorrichtungen 6 in diesem Beispiel als Gaslanzen 6 ausgebildet.

In einer beispielhaften Ausgestaltung des erfindungsgemäßen Verfahrens wird eine für das Selektivlöten vorbereitete Leiterplatte, nachdem sie die üblichen Funktionseinheiten wie Fluxer und Vorheizbereich passiert hat, in den Lötbereich transportiert. Unmittelbar vor der Ankunft der Leiterplatte im Lötbereich wird die Haube 5 soweit in vertikaler Richtung abgesenkt wie es in Abhängigkeit von der unterseitigen Bauteilgeometrie für einen ungestörten Selektivlötvorgang erforderlich ist. Beispielsweise wird auf ein 1 bis 2 mm unter dem tiefsten Punkt der zu lötenden Baugruppe liegendes Niveau abgesenkt. Dadurch kann eine Einsparung an Schutzgas und eine Verminderung der Krätzebildung während des Lötvorgangs erzielt werden. Die Leiterplatte wird auf der abgesenkten Haube 5 positioniert. Dann wird der Lötvorgang durchgeführt.

Nach Beendigung des Lötvorgangs wird die Haube 5 wieder in die Ausgangsstellung nach oben gefahren. Mit besonderem Vorteil wird dann nur noch mit einer gegenüber dem Lötvorgang verminderten Menge an Schutzgas begast. Dieser Modus kann auch als Stand-by-Modus bezeichnet werden. Durch den Schutzgaseintrag unter die Haube 5 im Stand-by-Modus werden die Düsen optimal weiterhin von Schutzgas umspült, wodurch die Krätzeproduktion an den oberen Enden der Düsen minimiert wird.

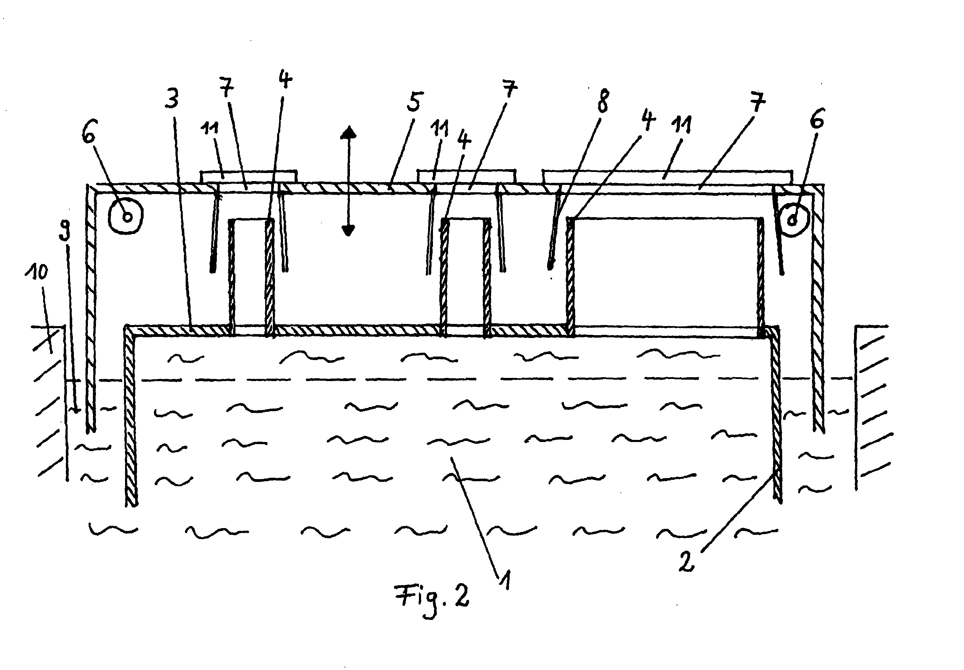

In der Figur 2 sind zusätzliche Bleche 11 gezeigt, die die Durchbrüche 7 zeitweise abdecken. Es ergibt sich ein besonderer Vorteil, wenn im Stand-by-Modus die Durchbrüche 7 in der Haube 5 mit den zusätzlichen Blechen 11 verschlossen werden, da die erforderliche Schutzgasmenge dadurch weiter reduziert und die Inertisierungswirkung verbessert werden kann. Die zusätzlichen Bleche 11 werden vorteilhaft mit der Absenkbewegung der Haube 5 zu Beginn eines Lötvorganges entfernt, so dass die Durchbrüche 7 während des Lötvorgangs offen sind. Erst mit der Aufwärtsbewegung der Haube 5 nach Beendigung eines Lötvorganges werden die zusätzlichen Bleche 11 wieder über den Durchbrüchen positioniert und diese damit verschlossen.

Durch die in der Figur 1 und in der Figur 2 gezeigten Strömungsbleche 8 kann die inertisierende Wirkung des Schutzgases weiter verbessert werden. In den vorliegenden Ausführungsbeispielen ist jedes Strömungsblech 8 als Konus geformt.

## Patentansprüche

1. Vorrichtung zum Selektivlöten aufweisend einen Behälter (10) für flüssiges Lot, der ein sog. Lotbad (9) enthält, mit einem Lotkanal (2) und mindestens einer auf den Lotkanal (2) aufgesetzten Düse (4) und einer Lotpumpe zum unter Druck Setzen von flüssigem Lot (1) im Lotkanal (2), wobei der Lotkanal (2) von einer vertikal bewegbaren Haube (5) umgeben ist, die in das Lotbad (9) eintaucht oder anderweitig zur Oberfläche des Lotbades (9) abgedichtet ist und die für jede Düse (4) einen Durchbruch (7) aufweist, und mindestens eine Eintragsvorrichtung (6) für Schutz- und/oder Aktivgas unter der Haube (5) vorgesehen ist, **dadurch gekennzeichnet dass** Strömungsbleche (8) an der Haube (5) angebracht sind, die sich von der Haube im wesentlichen abwärts Richtung Lotbad erstrecken.

2. Vorrichtung nach Anspruch 1, **dadurch gekennzeichnet, dass** das obere Ende der Düse (4) als Lötkopf zur Ausbildung einer Lötwelle ausgebildet ist.

3. Vorrichtung nach einem der Ansprüche 1 oder 2 **dadurch gekennzeichnet, dass** der obere Abschluss des Lotkanals (2) als Deckblech (3) ausgebildet ist.

4. Vorrichtung nach einem der Ansprüche 1 bis 3, **dadurch gekennzeichnet, dass** zur Abdeckung der Durchbrüche (7) zusätzliche Bleche (11) vorgesehen sind.

5. Verfahren zum Selektivlöten, das folgende Schritte aufweist:
1) eine zu lötende und dafür vorbereitete Leiterplatte wird in einen Lötbereich transportiert und über einer Haube (5) positioniert, wobei
2) entweder die Leiterplatte und die Haube (5) zeitgleich zusammen abgesenkt werden und/oder die Leiterplatte auf einer zuvor abgesenkten Haube (5) positioniert wird,
3) dann wird der Lötvorgang durchgeführt, wobei über die mindestens eine Düse (4) Lot aus einem Lotkanal (2) nach oben zur Lötstelle gepumpt wird und wobei während des Lötvorganges über eine Eintragsvorrichtung (6) Schutz- und/oder Aktivgas eingebracht wird und
4) nach Beendigung des Lötvorganges die Leiterplatte den Lötbereich verläßt und die Einhausung des Lötbereichs durch Anheben der Haube (5) wieder aufgehoben wird **dadurch gekennzeichnet, dass**
5) zwischen zwei Lötvorgängen die Durchbrüche (7) mit zusätzlichen, den einzelnen Durchbrüchen zugeordneten Blechen (11) abgedeckt werden, und dass eine Vorrichtung nach einem der Ansprüche 1 bis 4 verwendet wird.

6. Verfahren nach Anspruch 5, **dadurch gekennzeichnet, dass** einer erste Menge pro Zeiteinheit an Schutz- und/oder Aktivgas während des Lötvorganges eingebracht wird und eine zweite Menge pro Zeiteinheit an Schutz- und/oder Aktivgas zwischen zwei Lötvorgängen eingebracht wird.

7. Verfahren nach Anspruch 5 oder 6, **dadurch gekennzeichnet, dass** nach Beendigung des Lötvorganges die Menge des über die Eintragsvorrichtung (6) eingebrachten Schutz- und/oder Aktivgases gegenüber der während dem Lötvorgang eingebrachten Menge reduziert wird.

8. Verfahren nach einem der Ansprüche 5 bis 7, **dadurch gekennzeichnet, dass** die Haube (5) vor Beginn des Lötvorganges auf ein Niveau abgesenkt wird, das auf die unterseitige Bauteilgeometrie der Leiterplatte abgestimmt ist und etwas unter dem tiefsten Punkt der zu lötenden Baugruppe liegt.

## Claims

1. Device for selective soldering comprising a container (10) for liquid solder which contains a so-called soldering bath (9), with a soldering channel (2), at least one nozzle (4) mounted on the soldering channel (2) and a soldering pump for pressurizing liquid solder (1) in the soldering channel (2), wherein the soldering channel (2) is surrounded by a vertically movable hood (5) which is immersed into the soldering bath (9) or is sealed off otherwise with respect to the surface of the soldering bath (9) and which comprises a passage (7) for each nozzle (4), and at least one feeding device (6) for protective and/or active gas is provided underneath the hood (5), **characterized in that** flow plates (8) are attached to the hood (5) and extend substantially downward in the direction of the soldering bath from the hood.

2. Device according to Claim 1, **characterized in that** the upper end of the nozzle (4) is in the form of a soldering head for forming a soldering wave.

3. Device according to either of Claims 1 and 2, **characterized in that** the upper termination of the soldering channel (2) is in the form of a cover plate (3).

4. Device according to one of Claims 1 to 3, **characterized in that** additional plates (11) are provided for covering the passages (7).

5. Method for selective soldering comprising the following steps:
1) a printed circuit board which is to be soldered and has been prepared therefor is transported into a soldering region and positioned above a hood (5), wherein
2) either the printed circuit board and the hood (5) are lowered together at the same time and/or the printed circuit board is positioned on a previously lowered hood (5),
3) then, the soldering process is carried out, wherein solder is pumped via the at least one nozzle (4) from a soldering channel (2) upward to the soldering site and wherein protective and/or active gas is fed in during the soldering process via a feeding device (6), and
4) after the soldering process has been completed, the printed circuit board leaves the soldering region and the housing of the soldering region is raised again by raising the hood (5), **characterized in that**
5) the passages (7) are covered with additional plates (11), assigned to the individual passages, between two soldering processes, and **in that** a device according to one of Claims 1 to 4 is used.

6. Method according to Claim 5, **characterized in that** a first quantity per time unit of protective and/or active gas is fed in during the soldering process and a second quantity per time unit of protective and/or active gas is fed in between two soldering processes.

7. Method according to Claim 5 or 6, **characterized in that**, after the soldering process has been completed, the quantity of protective and/or active gas fed in via the feeding device (6) is reduced compared to the quantity fed in during the soldering process.

8. Method according to one of Claims 5 to 7, **characterized in that**, prior to the soldering process, the hood (5) is lowered to a level which is matched to the component geometry on the underside of the printed circuit board and lies slightly below the lowest point of the assembly which is to be soldered.

## Revendications

1. Dispositif de brasage sélectif comportant un réservoir (10) pour la brasure liquide, qui contient un bain de brasure (9), avec un canal à brasure (2) et au moins une buse (4) posée sur le canal à brasure (2) et une pompe à brasure pour la mise sous pression de brasure liquide (1) dans le canal à brasure (2), dans lequel le canal à brasure (2) est entouré d'une hotte (5) mobile verticalement, qui plonge dans le bain de brasure (9) ou est étanche d'une autre manière par rapport à la surface du bain de brasure (9) et qui présente un passage (7) pour chaque buse (4), et au moins un dispositif d'introduction (6) pour un gaz protecteur et/ou un gaz actif est prévu sous la hotte (5), **caractérisé en ce que** des déflecteurs (8) sont installés sur la hotte (5) et s'étendent de la hotte essentiellement en direction descendante vers le bain de brasure.

2. Dispositif selon la revendication 1, **caractérisé en ce que** l'extrémité supérieure de la buse (4) est réalisée comme une tête de brasage pour la formation d'une vague de brasage.

3. Dispositif selon l'une quelconque des revendications 1 à 2, **caractérisé en ce que** la paroi supérieure du canal à brasure (2) est réalisée comme une tôle de couverture (3).

4. Dispositif selon l'une quelconque des revendications 1 à 3, **caractérisé en ce qu'**il est prévu des tôles supplémentaires (11) pour recouvrir les passages (7).

5. Procédé de brasage sélectif, qui présente les étapes suivantes:
1) une plaquette de circuits imprimés à braser et préparée à cet effet est transportée dans une zone de brasage et positionnée au-dessus d'une hotte (5), dans lequel
2) soit la plaquette de circuits imprimés et la hotte (5) sont abaissées ensemble simultanément soit/et la plaquette de circuits imprimés est positionnée sur une hotte (5) préalablement abaissée,
3) on effectue alors l'opération de brasage, dans laquelle de la brasure est pompée vers le haut vers le point de brasage à partir d'un canal à brasure (2) par au moins une buse (4) et dans laquelle on introduit un gaz protecteur et/ou un gaz actif pendant l'opération de brasage via un dispositif d'introduction (6), et
4) à la fin de l'opération de brasage, la plaquette de circuits imprimés quitte la zone de brasage et l'enceinte de la zone de brasage est de nouveau relevée par soulèvement de la hotte (5), **caractérisé en ce que**
5) entre deux opérations de brasage, les passages (7) sont recouverts par des tôles supplémentaires (11) associées aux divers passages, et **en ce que** l'on utilise un dispositif selon l'une quelconque des revendications 1 à 4.

6. Procédé selon la revendication 5, **caractérisé en ce que** l'on introduit une première quantité de gaz protecteur et/ou de gaz actif par unité de temps pendant l'opération de brasage et on introduit une deuxième quantité de gaz protecteur et/ou de gaz actif par unité de temps entre deux opérations de brasage.

7. Procédé selon la revendication 5 ou 6, **caractérisé en ce que**, après la fin de l'opération de brasage, on réduit la quantité de gaz protecteur et/ou de gaz actif introduite via le dispositif d'introduction (6) par rapport à la quantité introduite pendant l'opération de brasage.

8. Procédé selon l'une quelconque des revendications 5 à 7, **caractérisé en ce que** l'on abaisse la hotte (5) avant le début de l'opération de brasage à un niveau qui est adapté à la géométrie des composants de la face inférieure de la plaquette de circuits imprimés et qui se situe légèrement en dessous du point le plus profond du module à braser.
